# EUROPEAN PATENT APPLICATION

(11) **EP 1 480 250 A1**
(43) Date of publication of application: **24.11.2004**
(21) Application number: 03405360.3
(22) Date of filing: 22.05.2003
(51) Int. Cl.: H01J 37/32, H05H 1/46

(54) **A high density plasma reactor and RF-antenna therefor**

(71) Applicant: HELYSSEN S.à.r.l., 1006 Lausanne (CH)
(72) Inventor: Chevalier, Eric, 74290 Veyrier du Lac (FR); Guittienne, Philippe, 1006 Lausanne (CH)
(74) Representative: Besse, François

(57) **Abstract**

The high density RF plasma source of this invention uses a special antenna configuration to launch waves at frequency such as 13,56 MHz. The antenna comprises several conductive loops around a common axis and spaced from each other along the axis. The loops are electrically connected by axial conductive segments, and each loop includes a plurality of serially connected capacitive elements. The tunability of this antenna allows to adapt actively the coupling of the RF energy (10) into an evolutive plasma as plasma processings in semiconductor manufacturing.

This plasma source can be used for the following applications: plasma etching, deposition and/or sputtering systems, space propulsion, plasma ― based sterilization, plasma abatment systems...

In another embodiment, the plasma source is in conjunction with a process chamber, this latter comprising an array of magnets (14) and RF coils (15,16) too. These elements can be used for in situ NMR Monitoring for moisture, for example, before or after the plasma process, or for in situ NMR Inspection for wafers or others workpieces (13). The RF coils allow the diagnostic and the active control of the plasma thanks to feedback control approach.

## Description

### FIELD OF THE INVENTION

The present invention relates to a method and apparatus for enhancing plasma source and associated processes.

### BACKGROUND OF THE INVENTION

Helicon wave discharges are known to efficiently produce high-density plasma, and have been exploited as a high density plasma tool for semiconductor processing (etching, deposition,sputtering...) [Lieberman M.A., Lichtenberg A.J., Principles of Plasma Discharges and Materials Processing, J. Wiley & Sons, 1994, New York.], space propulsion and basic plasma experiments. The plasma is usually generated in a cylindrical vacuum vessel in a longitudinal homogeneous magnetic field at 100 - 300 G or higher. The electromagnetic energy is transferred to the plasma source with frequencies between 1 and 50 MHz, usually with 13.56 MHz for processing plasmas. Helicon waves are generated in the plasma column by specially-shaped antennas.

The most common antenna used to excite helicon waves is the Nagoya Type III antenna [Okamura S, et al. 1986 Nucl. Fusion 26 1491], a modification of which is the double-saddle coil of Boswell [Boswell R.W. 1984, Plasma Phys. Control. Fusion,26 1147]. Helical antennae were first used by Shoji et al., and have been adapted such that single-loop antennae [Sakawa Y., Koshikawa N, Shoji T, 1996 Appl. Phys. Lett. 69 1695; Carter C. and Khachan J., 1999 Plasma Sources Sci. Technol. 8 432],double loop antennae [Tynan G.R. et al. 1997 J. Vac. Sci. Technol. A 15 2885; Degeling A.W., Jung C.O., Boswell R.W., Ellingboe A.R., 1996 Phys. Plasmas 3 2788], solenoid antennae [Kim J.H., Yun S.M., and Chang H.Y. 1996 Phys. Lett. A 221 94], and bifilar rotating-field antennae[Miljak D.G. and Chen F.F. 1998 Plasma Sources Sci. Technol. 7 61].

The damping of this wave can be explained by collisional theory [Chen F.F., Sudit I.D. and Light M., 1996 Plasma Sources Sci. Technol. 5 173], but collisionless (Landau) damping of helicon waves and the helicon wave transfer through the excitation of another wave at the boundary of the chamber called Trivelpiece-Gould mode has also been discussed [Chen F.F. Physical mechanisms in industrial RF plasma Sources, LTP-104, 2001, UCLA]. The type of discharge achieves electron densities up to 10¹² - 10¹³ cm⁻³ in the 0.1 Pa pressure range.

The main features which define the right antenna structure to excite Helicon waves for generation of plasmas are :
- Frequency of Excitation : It should be such that the waves satisfies: ωci < ω < ωc (ωci = ion cyclotron frequency, ωc = electron cyclotron frequency). Industrial standard frequency such as 13.56MHz are usually used in semiconductor processing.
- Wave mode : the mode structure of the wave electromagnetic fields generated so that an antenna arrangement can best be designed to efficiently couple the RF power into wave excitation. The two lowest modes are m=0 and m=1 modes. The best way to excite the mode m = 0 would be with two loops separated in distance by a a have-wavelength. For the mode m=1 there is a natural helical pitch to the electric and magnetic field vectors as the wave propagates along a principal axis. Given the state of the art, the current way to excite this mode is with a helical shaped antenna.
- Efficiency of coupling RF power to plasma : the efficiency of the plasma production depends on the coupling of RF energy into the plasma. An important mechanism for damping of the RF energy is Landau damping. The phase velocity of the helicon wave is given by ω/k_{z}, where k_{z} is given by the dispersion relation and depends on the plasma density and magnetic field strength. Ideally, the phase velocity of the wave should be near the maximum of the ionisation potential of the gas we wish to ionise. The higher the value of k_{z}, the higher the density. But if k_{z} is too high then the energy of the electrons may fall below the ionisation potential. It is therefore important to control k_{z} in order to be able to increase the density and control the electron temperature.

The conjonction of the plasma source with a process chamber where workpieces are located to either deposit, or etch films or to sputter deposit films to the workpieces is known. This processing system comprises, in particular, external magnet components and RF coils in order to be used as an in situ Nuclear Magnetic Resonance. The use of nuclear magnetic resonance (NMR) for physical, chemical and biological studies is very well developed and highly successful [P.J. Hore, Nuclear Magnetic Resonance, Oxford University Press, Oxford, UK, 1995]. The application of NMR for Plasma diagnostic techniques has recently been undertaken [Zweben S.J. et al., 2003, Rev. Sci. Inst., 74, 1460] for Tokamak experiments. The application of NMR in low pressure and/or temperature plasma processes in particular for moisture monitoring, contamination monitoring, chamber characterizations, in order to reduce the troubleshooting time of the equipment and improve the quality of manufactured devices, is still open.

### SUMMARY OF THE INVENTION

In accordance with the invention, there is provided a RF coil for plasma source having at least a pair of conductive loop elements spaced along a common longitudinal axis. Each of the loop elements includes a plurality of serially-connected capacitive elements spaced along the loop peripheries. A plurality of axial conductive elements electrically interconnect the conductive loop elements at points between adjacent ones of the serially-connected capacitive elements.

The invention uses one or multiple plasma source in conjonction with one or multiple process chamber to provide a high and uniform density over a large area inside the process chamber.

In another embodiment, the capacitive elements and/or moveable axial conductive elements are tuned such that to increase the coupling between the RF energy and the plasma, defining an active antenna.

In another embodiment, the main components in a process chamber can be used as an in situ monitoring of the environment inside the chamber or an in situ inspection of workpieces (such as wafer as part of semiconductor processes) based on the NMR principle.

### BRIEF DESCRIPTION OF THE DRAWINGS

- FIG. 1: is a schematic view of an antenna arrangement according to the present invention
- FIG. 2: is a schematic view of an antenna configuration in an another embodiment
- FIG. 3: is a schematic view of the basic configuration of a plasma source
- FIG 4: is a schematic view of an antenna configuration where axial conductive elements are twisted
- FIG.5: is a schematic view of a configuration of a plasma reactor comprising antennae inside and outside the reactor, and an array of elementary magnets.

### DETAILED DESCRIPTION

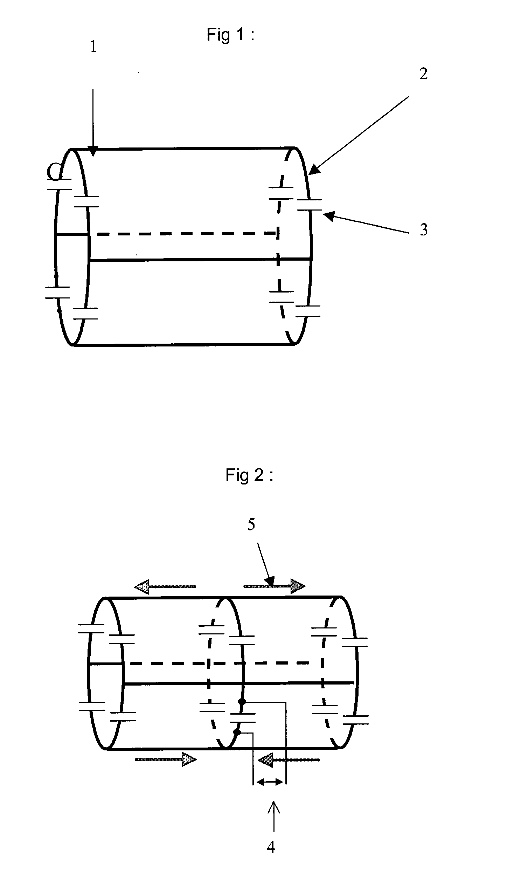

As can been seen on figures 1 and 2, the first principle structure of the present invention is the antenna configuration : RF current is made to flow through at least a pair of conductive loops (with any topology) **2** and axial conductive elements **1**. In such a way that the current is passing in the case of the Figure 2 configuration according to **5**. The RF voltage is applied from a RF power supply **4**.

One feature of the coil concerns the excitation. Excitation of the RF coil at a single excitation point results in a linearly polarized magnetic field B. Quadrature excitation can be achieved in a straight forward manner using the coil described in one possible configuration (see Figure 1). This can be accomplished by exciting the coil at two input capacitors **3** located at right angles relative to one another along the circumference of one conductive loop elements **2**. Additionally, to achieve the desired circular polarization, the RF sources used to excite the coil at two points must be electrically 90 degree out of phase relative to one another. In this manner, the two modes with approximately uniform transverse fields, as described above are excited.

A further feature of the antenna can be realized by utilizing multiple RF amplifiers to energize the antenna. Each amplifier is attached to different input capacitor, and the signal through each amplifier is phased correctly to produce the desired RF excitation. In this way, the power requirement from each amplifier is reduced as compared to the requirement for driving the antenna with one or two amplifiers. The antenna can be made with a solid round wire, in copper for example, or with a conductor consisting of a number of separately insulated strands that are twisted or braided together. Since each strand tends to take all possible positions in the cross section of the entire conductor, this design equalizes the flux linkages - and reactances - of the individual strands causing the current to spread uniformly throughout the conductor. The primary benefit is the reduction of AC losses. An example of such construction are known as Litz wire.

It should be recognized that the multiple amplifier configurations described above are merely exemplary and many other combinations utilizing four or more amplifiers are possible.

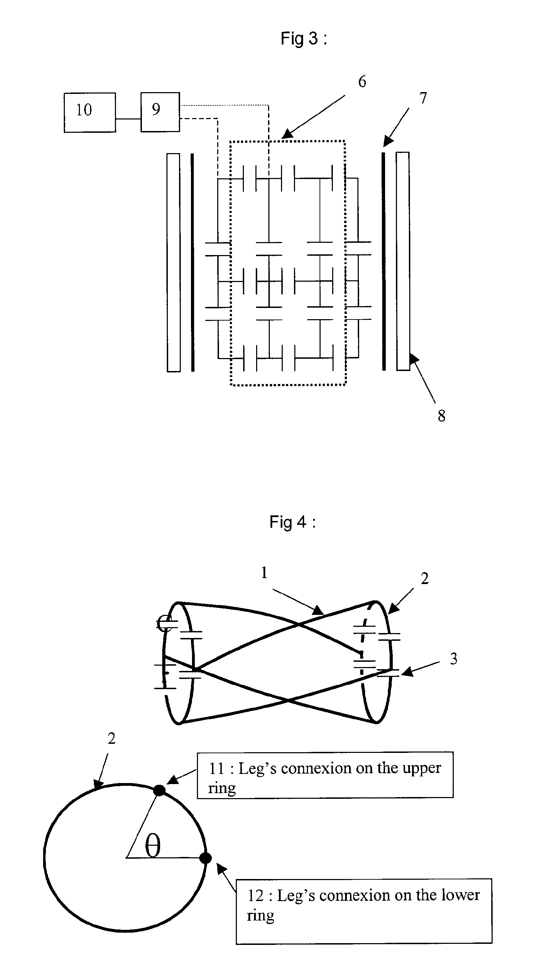

A basic configuration of the plasma source is shown on the Figure 3. with a Pyrex plasma chamber **6** surrounded by magnet field generators **8** placed on a pipe typically in PVC. The RF power **10** gives energy to the antenna through a matching network **9**.

A major advantage of this antenna is that the current distribution appears to be zero for every mode m≠±1. All the antenna power will be concentrated in those two modes. Experimentally the m=1 mode appears to be the more efficient for plasma heating with helicon waves. Another advantage is the high homogeneity of the plasma inside the chamber.

Especially in processing plasmas, the main features (density, electron temperature, ionic temperature, partial pressure species...) are dependent of the process time due to the interactions not only with the workpieces but also with the whole process chamber. That is why the possibility to adjust the coupling between the RF energy and the evolutive plasma allows high improvements of the process and the uptime of the equipment. We propose in another embodiment according the present invention to define an Active Antenna : where at least one capacitor is tunable and / or at least one conductive loop position is moveable, and / or at least one conductive loop rotation (→ twisted antenna) leading to a non zero angle between the axial conductive element's connexion on the first upper loop and the axial conductive element's connexion on the first lower loop, is moveable. A further configuration involves the feedback control of the active antenna according to sensors used as diagnostic techniques (magnetic probe, optical probe, Langmuir probe, Hall probe...).

In another embodiment according to the present invention, in order to enhance the perfomances of the plasma source it is possible to add close to the source a complementary source as Electron cyclotron resonance or Electron Bernstein wave.

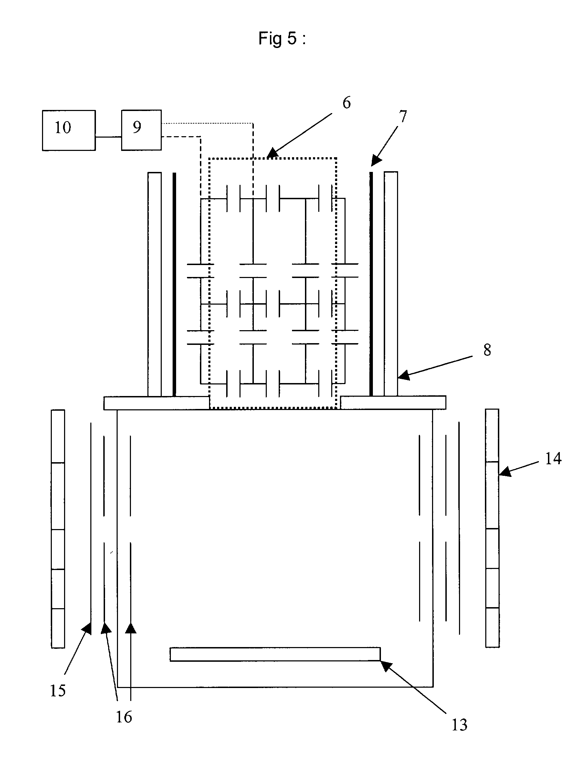

In another embodiment according to the present invention the plasma source is in conjonction with a process chamber (see Figure 5) comprising an array of magnets **14**, an array of RF coils outside the chamber walls **15**, and an array of RF coils inside the chamber **16**. The RF coils can be design as the one of the plasma source, that is to say with a plurality of capacitors. One part of the coils are used as feedback coils and the other part as sensor coils. It is possible to control the plasma stability by acquiring the coil sensor signal and, after treatment, to apply convenient current in order to improve the plasma behavior. The sensors coils can be remplaced by other type of sensors (optical probe, Hall probe,...)

In another embodiment according to the present invention, a serie of electrodes are added inside the process chamber on which typically an oscillating voltage. This action allows to confine the plasma and / or particles. The quadrupole electric fields of this trap exert radial forces on the charged partricles that are analogous to radial forces that a periodic focusing quadrupole magnetic field exert on charged particles.

In another embodiment according the present invention, we use the components of the process chamber (array of magnets and arrays of RF coils) to proceed to an in situ monitoring by Nuclear Magnetic Resonance. Indeed, we can apply a transient pulse of RF field through one or more coils. After tuning off the pulse(s), the emitted energy is measured as an alternating voltage induced in the same coil(s). The amplitude of this NMR signal is proportional to number of resonant spins in the observed object (Chamber wall, workpieces ...). But the absorbed excess energy is also dissipated due to interactions between the spins and their atomic and molecular environment as well as due to spin-spin interactions. These interactions are modulated in time by molecular motions giving rise to two relaxation processes. It leads for example that chemically combined water can be distinguished from water, which is physically bound to a solid surface and water, which is in the bulk liquid state.

It is possible to improve the monitoring by a magnetic field strength, which defines a gradient in a specific direction.

These NMR monitorings allow to improve significantly the process (before and after the plasma process, or after a preventive maintenance, it is possible to control the quality of the atmosphere, in particular the water rate), to optimise the uptime of the equipment and then the yield of the manufactured devices.

The main applications where the present invention is relevant are : plasma processing (semiconductor manufacturing, Microtechnologies, nanotechnologies), Plasma welding, plasma-based sterilization, Plasma cutting, space propulsion, plasma abatment systems, academic research...

Although the invention has been described and illustrated with particularity, it is intended to be illustrative of preferred embodiments. It is understood that the disclosure has been made by way of example only. Numerous changes in the combination and arrangements of the parts, steps and features can be made by those skilled in the art without departing from the spirit and scope of the invention, as hereinafter claimed.

## Claims

1. A plasma source apparatus, comprising :
a) an antenna designed to radiate electromagnetic waves,
b) a plasma generation chamber in the proximity of the antenna,
c) at least one magnetic field generator,
d) at least one fluid injector introducing at least one fluid into the plasma generation chamber,
e) a radio frequency generator,
f) a matching network, the matching network interconnecting the radio frequency generator and the antenna, thereby promoting the optimal transfer of radio frequency energy from the radio frequency generator to the antenna,
**characterized by** the fact that the antenna comprises at least a pair of conductive loop elements spaced along a common longitudinal axis, each of said conductive loop elements including at least one capacitive elements spaced along the peripheries thereof; and a plurality of axial conductive connected segments electrically interconnecting said conductive loop elements at points between adjacent ones of said serially-connected capacitive elements.

2. The apparatus of claim 1 wherein at least one serially- capacitive element is tunable

3. The apparatus of claim 1 wherein each of said axial conductive segments includes at least one capacitive element connected in series therewith.

4. The apparatus of claim 3 wherein at least one capacitive element connected is tunable

5. The apparatus according to anyone of the previous claims wherein each of said axial conductive segments are twisted.

6. The apparatus of claim 5 wherein one of the loop elements is moveable.

7. The apparatus of claim 6 wherein the twist angle depends on the axial direction, thanks to different rotations of several loop elements.

8. The apparatus according to anyone of the previous claims coupled with a complementary plasma source as Electron cyclotron resonance source

9. The apparatus according to anyone of the previous claims 1 to 7 coupled with an Electron Bernstein wave source.

10. A plasma processing apparatus comprising :
One or more plasma sources according to anyone of the previous claims, each plasma sources being cooperatively connected to one or a plurality of process chambers

11. The apparatus of claim 10 further comprising a plurality of RF coils, the RF coils being arranged preferably in a circumferential manner proximate to the process chamber.

12. The apparatus of claim 11 wherein at least one RF coils comprises capacitive elements

13. The apparatus of claims 11 or 12 further comprising a plurality of RF coils, the RF coils being arranged preferably in a circumferential manner inside the process chamber.

14. The apparatus of claims 11, 12, or 13 further comprising a plurality of magnets, the magnets being arranged preferably in a circumferential manner proximate to the process chamber.

15. The apparatus of claim 14 wherein the magnets define a spatial gradient of the magnetic field.

16. The apparatus of claim 11, or 12, or 13, or 14 further comprising a plurality of electrodes defining a Paul trap type or a Penning trap type on which typically an oscillating voltage is applied.

17. The apparatus of claim 1 wherein each of said axial conductive segments and/or conductive loops are made with volume conductive wire, or braids wire, typically Litz wire, or hollow wire.

18. A network of the antenna comprising a composition of several conductive loop elements including a plurality of serially- capacitive elements spaced along the peripheries thereof, where two conductive loops have at least one common axial conductive elements.

19. The method of using the apparatus of claims 14, 15 or 16 or 17 wherein in situ NMR monitoring of moisture for example and/ or in situ NMR inspection of process chamber are performed.

20. The method of using the apparatus of claims 11, or 12 wherein active feedback control of plasma is ensured on one hand by said feedback coils, and, on the other hand, by sensors, typically RF coils, Langmuir probe, Optical emission probe, Hall devices.

21. An antenna for a plasma source apparatus comprising:
At least a pair of conductive loop elements spaced along a common longitudinal axis, each of said conductive loop elements including at least one capacitive elements spaced along the peripheries thereof; a plurality of axial conductive connected segments electrically interconnecting said conductive loop elements at points between adjacent ones of said serially-connected capacitive elements; and one of conductive loop elements being moveable.
